# EUROPÄISCHE PATENTSCHRIFT

(11) **EP 2 002 545 B1**
(45) Veröffentlichungstag und Bekanntmachung des Hinweises auf die Patenterteilung: **07.04.2010**
(21) Anmeldenummer: 08701505.3
(22) Anmeldetag: 15.01.2008
(51) Int. Cl.: H03K 21/02, G01P 3/48, H03K 5/08

(54) **VERFAHREN UND VORRICHTUNG ZUM ERKENNEN VON IMPULSEN**
METHOD AND DEVICE FOR RECOGNIZING PULSES
PROCÉDÉ ET DISPOSITIF D'IDENTIFICATION D'IMPULSIONS

(30) Priorität: 01.02.2007 DE 102007005890
(43) Veröffentlichungstag der Anmeldung: 17.12.2008
(73) Patentinhaber: Continental Automotive GmbH, 30165 Hannover (DE)
(72) Erfinder: SEMMELRODT, Sven, 78662 Bösingen (DE)
(86) Internationale Anmeldenummer: PCT/EP2008/050397
(87) Internationale Veröffentlichungsnummer: WO 2008/092738

(56) Entgegenhaltungen:
- EP-A- 0 955 522
- DE-A1- 19 732 960
- US-A- 5 497 084

## Beschreibung

Die Erfindung betrifft ein Verfahren und eine Vorrichtung zum Erkennen von Impulsen und insbesondere zum Erkennen von Impulsen, die durch ein Impulsgeberrad und einen Sensor erzeugt werden, der zum Beispiel ein Hall-Element umfasst, zum Ermitteln einer Drehzahl, insbesondere in einem Getriebe eines Fahrzeugs.

In der EP 1 111 392 A1 ist das Erfassen einer Drehzahl und Winkelstellung eines rotierenden Rades mit anpassbarer Schaltschwelle zur Driftkompensation offenbart. Ein Sensor tastet Abtastmarken des Rades berührungslos ab und erzeugt eine Impulsfolge. Eine Amplitude der Impulse wird in einem Vergleicher mit einer variablen Schaltschwelle von einer Auswerteschaltung mit Synchrondetektor und Filter verglichen. Um ein möglichst genaues Messergebnis zu erzielen und einen Offset sowie eine Langzeitdrift des Sensors weitestgehend zu kompensieren, wird die Schaltschwelle angepasst, wenn eine oder mehrere Bedingungen erfüllt sind.

In der DE 699 10 741 T2 ist eine Schaltung zur Feststellung einer Änderung in einem magnetischen Feld offenbart. Ein Differenzsignal wird erzeugt aus einem Ausgangssignal von Magnetfeldsensoren. Ein Spitzenwert des Differenzsignals wird erkannt und verfolgt. Eine Schwellenwertjustierschaltung ist vorgesehen zum Einstellen eines Schwellenwerts gemäß einer Größe des Differenzsignals.

Die Aufgabe der Erfindung ist, ein Verfahren und eine Vorrichtung zum Erkennen von Impulsen zu schaffen, das beziehungsweise die zuverlässig ist.

Die Aufgabe wird gelöst durch die Merkmale der unabhängigen Patentansprüche. Vorteilhafte Weiterbildungen der Erfindung sind in den Unteransprüchen gekennzeichnet.

Die Erfindung zeichnet sich aus durch ein Verfahren und eine entsprechende Vorrichtung zum Erkennen von Impulsen in einem Eingangssignal. Eine Folge von Abtastwerten, die abhängig von dem Eingangssignal gebildet ist oder die durch das Eingangssignal gebildet ist, wird transformiert in eine Folge von Transformationswerten durch Hinzufügen jeweils eines einen aktuellen Abtastwert der Folge von Abtastwerten repräsentierenden Transformationswerts zu der Folge von Transformationswerten, wenn dieser aktuelle Abtastwert der Folge von Abtastwerten mindestens um einen vorgegebenen Betragswert von einem vorgegebenen Referenzabtastwert abweicht. Der aktuelle Abtastwert der Folge von Abtastwerten, der mindestens um den vorgegebenen Betragswert von dem vorgegebenen Referenzabtastwert abweicht, wird als der vorgegebene Referenzabtastwert vorgegeben für nachfolgend aktuelle Abtastwerte. Abhängig von der Folge von Transformationswerten wird ein gleitender Mittelwert ermittelt. Impulse in dem Eingangssignal werden erkannt abhängig von dem gleitenden Mittelwert.

Beispielsweise wird ein Schwellenwert für das Erkennen der Impulse abhängig von dem gleitenden Mittelwert vorgegeben, insbesondere kann der gleitende Mittelwert auch direkt den Schwellenwert bilden. Ein Vorteil ist, dass durch die Transformation eine Dezimierung der Folge von Abtastwerten bewirkbar ist. Dadurch müssen für eine weitere Verarbeitung im Vergleich zu einer Anzahl der Abtastwerte nur wenige Transformationswerte gespeichert und berücksichtigt werden. Dadurch kann die Vorrichtung sehr einfach und kostengünstig ausgebildet werden. Insbesondere ist die Vorrichtung dadurch einfach und kostengünstig in einer anwendungsspezifischen integrierten Schaltung implementierbar, die auch als ASIC bezeichnet werden kann. Das Verfahren ist jedoch auch als ein Programm implementierbar, das zum Beispiel auf einem Mikrocontroller ausführbar ist.

Ein weiterer Vorteil ist, dass ein im Vergleich zu einer Frequenz der Impulse langsam veränderlicher Amplitudenversatz, der auch als ein Offset oder als Drift bezeichnet werden kann, einfach und zuverlässig kompensierbar ist. Dies gilt insbesondere auch dann, wenn das Eingangssignal verrauscht ist und/oder der Amplitudenversatz größer ist als eine Amplitude der Impulse. Ferner ist die Kompensation auch dann zuverlässig möglich, wenn eine Frequenzdynamik der Impulse groß ist, zum Beispiel wenn eine Frequenz der Impulse zwischen etwa 1 Hz und 10 kHz veränderlich ist. Das Verfahren und die Vorrichtung sind insbesondere geeignet für das Erkennen von Impulsen, die für ein Ermitteln einer Drehzahl in einem Getriebe eines Fahrzeugs genutzt werden und die durch Nutzen eines statischen Sensorprinzips erfasst werden mit einem Permanentmagneten und einem Hall-Element als Sensor. Der Amplitudenversatz ist beispielsweise durch eine Wirbelstrombremse verursacht.

In einer vorteilhaften Ausgestaltung wird der aktuelle Abtastwert der Folge von Abtastwerten, der mindestens um den vorgegebenen Betragswert von dem vorgegebenen Referenzabtastwert abweicht, als der Transformationswert der Folge von Transformationswerten hinzugefügt. Der Vorteil ist, dass dies besonders einfach ist.

In einer weiteren vorteilhaften Ausgestaltung wird eine Amplitude mindestens eines Impulses ermittelt. Der vorgegebene Betragswert wird vorgegeben abhängig von der ermittelten Amplitude des mindestens einen Impulses und einer vorgegebenen Anzahl von Amplitudenabschnitten, in die die ermittelte Amplitude des mindestens einen Impulses unterteilt werden soll. Dies hat den Vorteil, dass eine Justierung des vorgegeben Betragswerts sehr einfach automatisch erfolgen kann. Ein manuelles Justieren ist dann nicht erforderlich. Dadurch können Kosten gespart werden.

In einer weiteren vorteilhaften Ausgestaltung wird das Eingangssignal oder ein von diesem abgeleitetes Signal einer Schwellenwertschalteinheit zugeführt. Ferner wird der Schwellenwertschalteinheit der gleitende Mittelwert als Schwellenwert oder ein abhängig von dem gleitenden Mittelwert ermittelter Schwellenwert vorgegeben. Die Schwellenwertschalteinheit ist vorzugsweise als ein digitaler Vergleicher ausgebildet, der den jeweiligen digital kodierten Abtastwert mit dem jeweiligen digital kodierten Schwellenwert vergleicht. Der Vorteil ist, dass dies sehr einfach und kostengünstig implementierbar ist.

Ausführungsbeispiele der Erfindung sind im Folgenden anhand der schematischen Zeichnungen erläutert.

Es zeigen:
Figur 1 eine Vorrichtung zum Erkennen von Impulsen,
Figur 2 ein Diagramm mit einem ersten zeitlichen Verlauf einer Folge von Abtastwerten,
Figur 3A ein Diagramm mit einem zweiten zeitlichen Verlauf der Folge von Abtastwerten,
Figur 3B ein Diagramm mit einem zeitlichen Verlauf einer Folge von Transformationswerten und
Figur 4 ein Ablaufdiagramm eines Programms zum Erkennen von Impulsen.

Elemente gleicher Konstruktion oder Funktion sind figurenübergreifend mit den gleichen Bezugszeichen versehen.

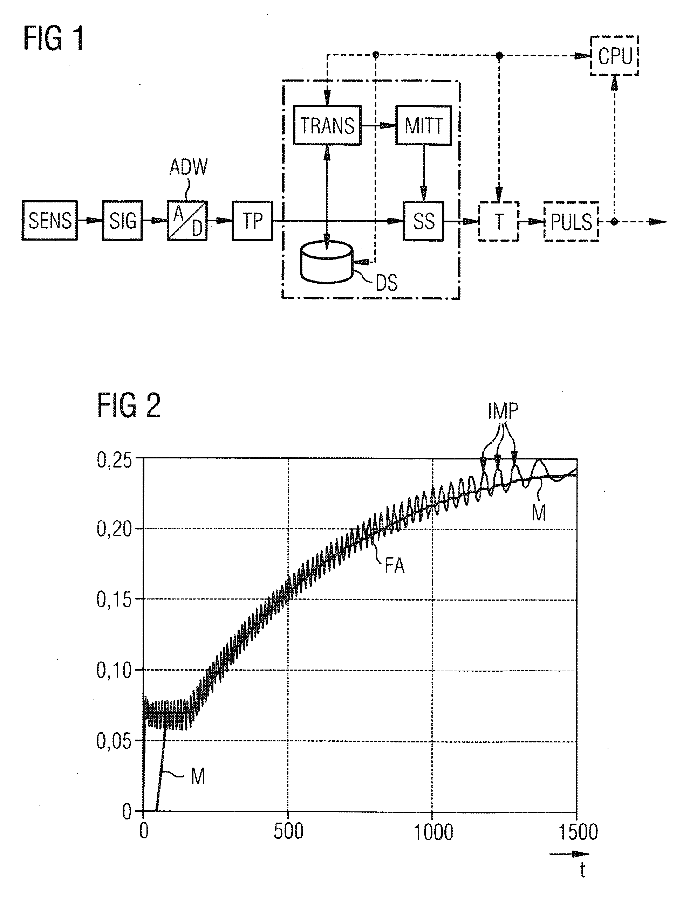

Eine Sensoreinheit SENS ist vorgesehen zum Erfassen eines Signals (Figur 1). Die Sensoreinheit SENS umfasst beispielsweise ein Hall-Element und ist ausgebildet, das Signal abhängig von einem vorherrschenden Magnetfeld zu erzeugen. Beispielsweise wird das Magnetfeld erzeugt durch einen Permanentmagneten, der bei einem Geberrad angeordnet ist, dass an einem rotierenden Bauteil, zum Beispiel einer Welle, befestigt ist. Durch eine Rotation des Geberrads entstehen Impulse IMP in dem Signal, deren Frequenz abhängig ist von einer Rotationsgeschwindigkeit des Geberrads. Die Sensoreinheit SENS und das Geberrad sind beispielsweise in einem Getriebe angeordnet. Abhängig von den Impulsen IMP ist eine Drehzahl des Geberrads und somit des rotierenden Bauteils ermittelbar.

Die Sensoreinheit SENS ist gekoppelt mit einer Signalverarbeitungseinheit SIG, der das erfasste Signal zuführbar ist. Vorzugsweise ist die Signalverarbeitungseinheit SIG ausgebildet, das Signal analog vorzuverarbeiten, zum Beispiel zu verstärken und zu filtern. Die Signalverarbeitungseinheit SIG ist mit einer Analog-Digital-Wandlereinheit ADW gekoppelt, der das vorverarbeitete Signal zuführbar ist. Die Analog-Digital-Wandlereinheit ADW ist ausgebildet, das erfasste und vorverarbeitete Signal zu digitalisieren, das heißt abzutasten. Eine Filtereinheit und insbesondere eine Tiefpassfiltereinheit TP ist vorzugsweise vorgesehen, das digitalisierte Signal zu filtern und insbesondere tiefpasszufiltern.

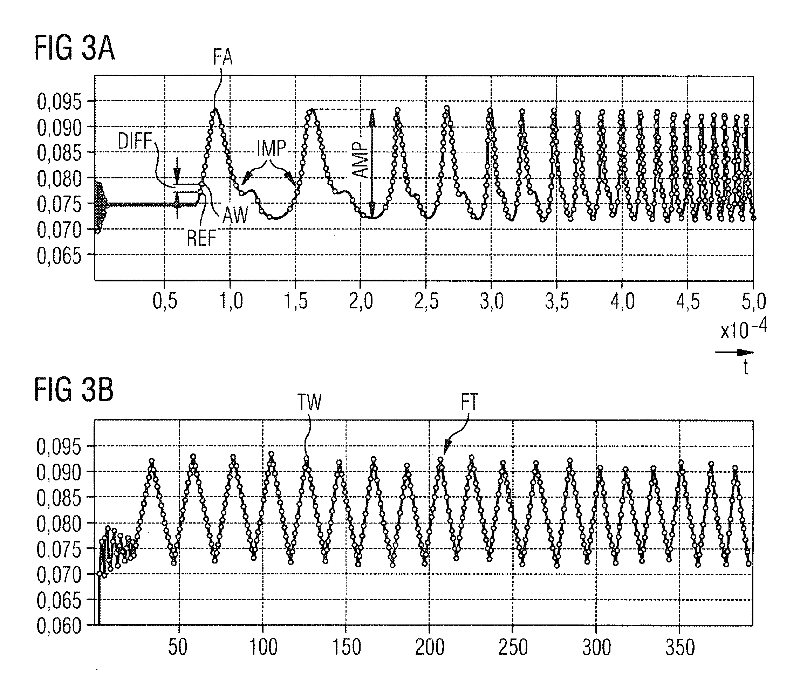

Das durch die Analog-Digital-Wandlereinheit ADW digitalisierte und gegebenenfalls durch die Filtereinheit gefilterte Signal bildet eine Folge FA von Abtastwerten AW, die einer Vorrichtung zum Erkennen von Impulsen IMP als ein Eingangssignal zuführbar ist. Ein erster und ein zweiter Verlauf der Folge FA von Abtastwerten AW sind beispielhaft in Figuren 2 und 3A dargestellt. Die Vorrichtung ist eingangsseitig gekoppelt mit der Filtereinheit und umfasst eine Transformationseinheit TRANS, eine Mittelungseinheit MITT und eine Schwellenwertschalteinheit SS. Vorzugsweise ist auch ein Datenspeicher DS vorgesehen zum Zwischenspeichern von Abtastwerten AW der Folge FA von Abtastwerten AW.

Die Transformationseinheit TRANS ist eingangsseitig gekoppelt mit der Filtereinheit und/oder mit dem Datenspeicher DS. Das Eingangssignal ist der Transformationseinheit TRANS zuführbar. Die Transformationseinheit TRANS ist ausgebildet zum Transformieren der Folge FA von Abtastwerten AW in eine Folge FT von Transformationswerten TW. Ein Verlauf der Folge FT von Transformationswerten TW ist beispielhaft in Figur 3B dargestellt. Das Transformieren umfasst ein Dezimieren der Folge FA von Abtastwerten AW, so dass eine Anzahl von Transformationswerten TW in der Folge FT von Transformationswerten TW geringer ist als eine Anzahl von Abtastwerten AW in der Folge FA von Abtastwerten AW. Die Transformationseinheit TRANS kann daher auch als Dezimierungseinheit bezeichnet werden.

Die Mittelungseinheit MITT ist eingangsseitig gekoppelt mit einem Ausgang der Transformationseinheit TRANS, an dem diese die Folge FT von Transformationswerten TW bereitstellt. Die Mittelungseinheit MITT ist ausgebildet zum Bilden eines gleitenden Mittelwerts M abhängig von der Folge FT von Transformationswerten TW, beispielsweise als ein arithmetisches Mittel über alle Transformationswerte TW, die innerhalb eines Mittelungsfensters vorgegebener Breite oder vorgegebener Anzahl von Transformationswerten TW liegen, wobei das Mittelungsfenster in vorgegebenen Schritten über die Folge FT von Transformationswerten TW bewegt wird und das jeweils ermittelte arithmetische Mittel ausgangsseitig als der gleitende Mittelwert M bereitgestellt wird. Es ist jedoch auch möglich, den gleitenden Mittelwert M anders zu ermitteln, zum Beispiel rekursiv, indem der aktuelle gleitende Mittelwert M ermittelt wird abhängig von einem gewichteten, zuvor ermittelten, gleitenden Mittelwert M und einem gewichteten, aktuellen Transformationswert TW. Die Mittelungseinheit MITT kann ferner ausgebildet sein, einen Schwellenwert für das Erkennen der Impulse IMP abhängig von dem gleitenden Mittelwert M zu ermitteln, zum Beispiel durch Adaption des Schwellenwerts abhängig von einem Verlauf des gleitenden Mittelwerts M. Vorzugsweise ist der Schwellenwert jedoch durch den gleitenden Mittelwert M gebildet. Die Mittelung erfolgt vorzugsweise jeweils über so viele aufeinander folgende Transformationswerte TW, dass diese sich zusammen über mindestens einen Impuls IMP erstrecken. Dadurch folgt der gleitende Mittelwert M nur Signaländerungen, die langsamer sind als Signaländerungen, die durch den jeweiligen Impuls IMP verursacht werden.

Die Schwellenwertschalteinheit SS ist eingangseitig gekoppelt mit der Filtereinheit, das heißt der Tiefpassfiltereinheit TP, oder mit dem Datenspeicher DS. Die Folge FA von Abtastwerten AW sind der Schwellenwertschalteinheit SS so zuführbar. Ferner ist die Schwellenwertschalteinheit SS eingangsseitig gekoppelt mit der Mittelungseinheit MITT. So ist der Schwellenwertschalteinheit SS ferner der Schwellenwert und insbesondere der gleitende Mittelwert M zuführbar. Die Schwellenwertschalteinheit SS ist ausgebildet zum Erkennen der Impulse IMP abhängig von dem Schwellenwert beziehungsweise dem gleitenden Mittelwert M. Beispielsweise wird ein Impuls IMP erkannt, wenn ein Abtastwert AW der Folge FA von Abtastwerten AW größer ist als der Schwellenwert beziehungsweise der gleitende Mittelwert M. Es kann jedoch ebenso vorgesehen sein, einen Impuls IMP zu erkennen, wenn ein Abtastwert AW der Folge FA von Abtastwerten AW kleiner ist als der Schwellenwert beziehungsweise der gleitende Mittelwert M. Ferner kann auch eine Hysterese vorgesehen sein, so dass ein Überschreiten eines ersten Schwellenwerts erkannt wird, der abhängig von dem gleitenden Mittelwert M vorgegeben wird, und ein Unterschreiten eines zweiten Schwellenwerts erkannt wird, der abhängig von dem gleitenden Mittelwert M vorgegeben wird. Die Schwellenwertschalteinheit SS ist ferner ausgebildet, die erkannten Impulse IMP ausgangsseitig bereitzustellen, zum Beispiel in Form eines digitalen Werts Eins oder Null abhängig davon, ob ein Impuls IMP erkannt wurde oder nicht erkannt wurde. Die Schwellenwertschalteinheit SS ist beispielsweise als ein digitaler Vergleicher ausgebildet, der den jeweiligen digital kodierten Abtastwert AW mit dem jeweiligen digital kodierten Schwellenwert vergleicht.

Zur weiteren Verarbeitung der erkannten Impulse IMP kann beispielsweise eine Teilereinheit T vorgesehen sein, die ausgebildet ist, eine Frequenz der erkannten Impulse IMP um einen vorgegebenen Teilungsfaktor zu reduzieren. Ferner kann eine Impulsformungseinheit PULS vorgesehen sein, um die erkannten Impulse IMP gegebenenfalls für andere Einheiten geeignet aufzubereiten. Ferner kann eine Recheneinheit CPU vorgesehen sein, mittels der beispielsweise der vorgegebene Teilungsfaktor vorgebbar ist oder mittels der beispielsweise eine Justierung eines Parameters auslösbar ist, zum Beispiel die Justierung eines vorgegebenen Betragswerts, der für das Transformieren der Folge FA von Abtastwerten AW in die Folge FT von Transformationswerten TW erforderlich ist. Die Recheneinheit CPU kann auch vorgesehen sein zum Steuern des Datenspeichers DS.

Die Vorrichtung ist vorzugsweise als eine Digitalschaltung ausgebildet und ist vorzugsweise als eine anwendungsspezifische integrierte Schaltung ausgebildet. Die anwendungsspezifische integrierte Schaltung kann auch die Signalverarbeitungseinheit SIG und/oder die Analog-Digital-Wandlereinheit ADW und/oder die Tiefpassfiltereinheit TP und gegebenenfalls auch die Teilereinheit T und/oder die Impulsformungseinheit PULS und/oder die Recheneinheit CPU und/oder die Sensoreinheit SENS und insbesondere das Hall-Element umfassen.

Figur 2 zeigt beispielhaft den ersten Verlauf der Folge FA von Abtastwerten AW und des zugehörigen gleitenden Mittelwerts M. Auf der Zeitachse des Diagramms sind die Nummern der Abtastwerte AW aufgetragen, in dem Diagramm sind also insgesamt 1500 Abtastwerte AW dargestellt. Der in Figur 2 gezeigte erste Verlauf kann beispielsweise dadurch entstehen, dass das Fahrzeug, das anfangs mit etwa konstanter Geschwindigkeit fährt, bremst, zum Beispiel unter Nutzung der Wirbelstrombremse. Durch das Bremsen nimmt die Geschwindigkeit des Fahrzeugs und entsprechend auch die Drehzahl ab. Entsprechend nimmt auch die Frequenz der Impulse IMP ab. Durch das Betätigen der Wirbelstrombremse entsteht ein ansteigender Amplitudenversatz. Jedoch wird der Schwellenwert, das heißt der gleitende Mittelwert M, zuverlässig nachgeführt, so dass die Impulse IMP weiterhin zuverlässig erkennbar sind.

Figur 3A zeigt den zweiten Verlauf der Folge FA von Abtastwerten AW und Figur 3B zeigt einen zugehörigen Verlauf der Folge FT von Transformationswerten TW. Die Transformation erfolgt derart, dass ausgehend von einem vorgegebenen Referenzabtastwert REF eine Differenz DIFF eines nachfolgenden Abtastwerts AW zu dem vorgegebenen Referenzabtastwert REF ermittelt wird. Übersteigt die Differenz DIFF den vorgegebenen Betragswert MDIFF, dann wird dieser Abtastwert AW als Transformationswert TW zu der Folge FT von Transformationswerten TW hinzugefügt. Ferner wird dieser Abtastwert AW als der vorgegebene Referenzabtastwert REF für die nachfolgenden Abtastwerte AW vorgegeben. Übersteigt die Differenz DIFF den vorgegebenen Betragswert MDIFF jedoch nicht, dann wird entsprechend für den nachfolgenden Abtastwert AW die Differenz DIFF zu dem Referenzabtastwert REF ermittelt und mit dem vorgegebenen Betragswert MDIFF verglichen. In Figur 3A sind diejenigen Abtastwerte AW, deren Differenz DIFF größer ist als der jeweils vorgegebene Referenzabtastwert REF, mit einem Kringel gekennzeichnet. In Figur 3B bilden diese Abtastwerte AW die Transformationswerte TW. Zur deutlicheren Darstellung sind jeweils aufeinander folgende Transformationswerte TW mit einer Linie verbunden.

Die Transformation ist durch den vorgegebenen Betragswert MDIFF als Parameter beeinflussbar. Bevorzugt ist vorgesehen, den vorgegebenen Betragswert MDIFF automatisch zu ermitteln. Dazu ist vorzugsweise vorgesehen, eine Amplitude AMP mindestens eines Impulses IMP zu ermitteln durch Ermitteln eines Maximalwerts und eines Minimalwerts. Der vorgegebene Betragswert MDIFF wird dann vorzugsweise vorgegeben durch Dividieren der ermittelten Amplitude AMP durch eine vorgegebene Anzahl von Amplitudenabschnitten, in die die ermittelte Amplitude AMP unterteilt werden soll. So ist der vorgegebene Betragswert MDIFF sehr einfach an die Amplitude AMP der Impulse IMP anpassbar.

Die Transformation hat den Vorteil, dass sich für das Ermitteln des gleitenden Mittelwerts M eine Impulsfolge mit im Wesentlichen konstanter Frequenz ergibt. Die konstante Frequenz ist insbesondere im Wesentlichen unabhängig von der Frequenz der Impulse IMP in dem Eingangssignal. Dadurch ist der gleitende Mittelwert M präzise und zuverlässig für einen weiten Frequenzbereich der Impulse IMP ermittelbar. Entsprechend präzise und zuverlässig ist auch der Schwellenwert für das Erkennen der Impulse IMP. Der Schwellenwert kann so auch bei einem verrauschten Eingangssignal und bei einem großen Amplitudenversatz zuverlässig nachgeführt werden. Der Frequenzbereich beträgt beispielsweise etwa 1 Hz bis 10 kHz. Der Frequenzbereich kann jedoch auch anders ausgebildet sein.

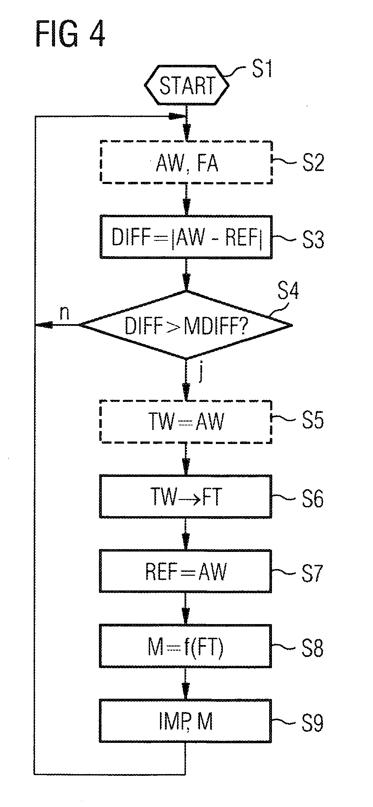

Figur 4 zeigt ein Ablaufdiagramm eines Programms zum Erkennen der Impulse IMP. Das Programm beginnt in einem Schritt S1. In dem Schritt S1 wird beispielsweise der vorgegebene Referenzabtastwert REF vorgegeben. Beispielsweise wird der erste Abtastwert AW als vorgegebener Referenzabtastwert REF vorgegeben. Der vorgegebene Referenzabtastwert REF kann jedoch auch anders vorgegeben werden.

Ein Schritt S2 kann vorgesehen sein, jeweils in einem vorgegebenen zeitlichen Abstand einen Abtastwert AW zu erfassen und so die Folge FA von Abtastwerten AW zu erzeugen, falls diese nicht bereits verfügbar ist. In einem Schritt S3 wird die Differenz DIFF gebildet als Betrag der Differenz zwischen dem jeweils aktuellen Abtastwert AW und dem vorgegebenen Referenzabtastwert REF. In einem Schritt S4 wird überprüft, ob die Differenz DIFF größer ist als der vorgegebene Betragswert MDIFF. Ist diese Bedingung nicht erfüllt, dann wird das Programm in dem Schritt S2 oder dem Schritt S3 mit dem nächsten aktuellen Abtastwert AW fortgesetzt. Ist die Bedingung in dem Schritt S4 jedoch erfüllt, dann wird in einem Schritt S5 der aktuelle Abtastwert AW als nächster Transformationswert TW gewählt und in einem Schritt S6 zu der Folge FT von Transformationswerten TW hinzugefügt. Es kann jedoch auch vorgesehen sein, anstatt des aktuellen Abtastwerts AW der Folge FT von Transformationswerten TW einen Wert hinzuzufügen, der abhängig von dem aktuellen Abtastwert AW ermittelt wird. Beispielsweise kann vorgesehen sein, den aktuellen Abtastwert AW mit einem vorgegebenen Faktor zu multiplizieren und/oder einen Amplitudenversatzwert zu addieren oder subtrahieren, bevor der so ermittelte Wert als Transformationswert TW der Folge FT von Transformationswerten TW hinzugefügt wird. Es können jedoch auch weitere oder andere Modifikationen des aktuellen Abtastwerts AW vorgesehen sein. Der Wert, der abhängig von dem aktuellen Abtastwert AW ermittelt und der Folge FT von Transformationswerten TW als Transformationswert TW hinzugefügt wird, repräsentiert dann den aktuellen Abtastwert AW.

In einem Schritt S7 wird der aktuelle Abtastwert AW als der vorgegebene Referenzabtastwert REF vorgeben für nachfolgend aktuelle Abtastwerte AW. In einem Schritt S8 wird der gleitende Mittelwert abhängig von der Folge FT von Transformationswerten TW ermittelt. Ferner kann vorgesehen sein, den Schwellenwert abhängig von dem ermittelten gleitenden Mittelwert M zu ermitteln. In einem Schritt S9 wird ein Impuls IMP abhängig von dem gleitenden Mittelwert M beziehungsweise von dem Schwellenwert erkannt. Das Programm wird in dem Schritt S2 oder dem Schritt S3 fortgesetzt für den nächsten aktuellen Abtastwert AW.

## Patentansprüche

1. Verfahren zum Erkennen von Impulsen (IMP) in einem Eingangssignal, bei dem
- eine Folge (FA) von Abtastwerten (AW), die abhängig von dem Eingangssignal gebildet ist oder die durch das Eingangssignal gebildet ist, transformiert wird in eine Folge (FT) von Transformationswerten (TW) durch Hinzufügen jeweils eines einen aktuellen Abtastwert (AW) der Folge (FA) von Abtastwerten (AW) repräsentierenden Transformationswerts (TW) zu der Folge (FT) von Transformationswerten (TW), wenn dieser aktuelle Abtastwert (AW) der Folge (FA) von Abtastwerten (AW) mindestens um einen vorgegebenen Betragswert (MDIFF) von einem vorgegebenen Referenzabtastwert (REF) abweicht,
- der aktuelle Abtastwert (AW) der Folge (FA) von Abtastwerten (AW), der mindestens um den vorgegebenen Betragswert (MDIFF) von dem vorgegebenen Referenzabtastwert (REF) abweicht, als der vorgegebene Referenzabtastwert (REF) vorgegeben wird für nachfolgend aktuelle Abtastwerte (AW),
- abhängig von der Folge (FT) von Transformationswerten (TW) ein gleitender Mittelwert (M) ermittelt wird und
- Impulse (IMP) in dem Eingangssignal erkannt werden abhängig von dem gleitenden Mittelwert (M).

2. Verfahren nach Anspruch 1, bei dem der aktuelle Abtastwert (AW) der Folge (FA) von Abtastwerten (AW), der mindestens um den vorgegebenen Betragswert (MDIFF) von dem vorgegebenen Referenzabtastwert (REF) abweicht, als der Transformationswert (TW) der Folge (FT) von Transformationswerten (TW) hinzugefügt wird.

3. Verfahren nach einem der vorstehenden Ansprüche, bei dem
- eine Amplitude (AMP) mindestens eines Impulses (IMP) ermittelt wird und
- der vorgegebene Betragswert (MDIFF) vorgegeben wird abhängig von der ermittelten Amplitude (AMP) des mindestens einen Impulses (IMP) und einer vorgegebenen Anzahl von Amplitudenabschnitten, in die die ermittelte Amplitude (AMP) des mindestens einen Impulses (IMP) unterteilt werden soll.

4. Verfahren nach einem der vorstehenden Ansprüche, bei dem das Eingangssignal oder ein von diesem abgeleitetes Signal einer Schwellenwertschalteinheit (SS) zugeführt wird und der Schwellenwertschalteinheit (SS) der gleitende Mittelwert (M) als Schwellenwert oder ein abhängig von dem gleitenden Mittelwert (M) ermittelter Schwellenwert vorgegeben wird.

5. Vorrichtung zum Erkennen von Impulsen (IMP) in einem Eingangssignal, die ausgebildet ist
- zum Transformieren einer Folge (FA) von Abtastwerten (AW), die abhängig von dem Eingangssignal gebildet ist oder die durch das Eingangssignal gebildet ist, in eine Folge (FT) von Transformationswerten (TW) durch Hinzufügen jeweils eines einen aktuellen Abtastwert (AW) der Folge (FA) von Abtastwerten (AW) repräsentierenden Transformationswerts (TW) zu der Folge (FT) von Transformationswerten (TW), wenn dieser aktuelle Abtastwert (AW) der Folge (FA) von Abtastwerten (AW) mindestens um einen vorgegebenen Betragswert (MDIFF) von einem vorgegebenen Referenzabtastwert (REF) abweicht,
- zum Vorgeben des aktuellen Abtastwerts (AW) der Folge (FA) von Abtastwerten (AW), der mindestens um den vorgegebenen Betragswert (MDIFF) von dem vorgegebenen Referenzabtastwert (REF) abweicht, als den vorgegebenen Referenzabtastwert (REF) für nachfolgend aktuelle Abtastwerte (AW),
- zum Ermitteln eines gleitenden Mittelwerts (M) abhängig von der Folge (FT) von Transformationswerten (TW) und
- zum Erkennen von Impulsen (IMP) in dem Eingangssignal abhängig von dem gleitenden Mittelwert (M).

## Claims

1. Method for recognizing pulses (IMP) in an input signal, in which method
- a sequence (FA) of sample values (AW), which is formed as a function of the input signal or which is formed by the input signal, is transformed into a sequence (FT) of transformation values (TW) by in each case adding a transformation value (TW), which represents a current value sample value (AW) of the sequence (FA) of sample values (AW), to the sequence (FT) of transformation values (TW) when this current sample value (AW) of the sequence (FA) of sample values (AW) deviates from a predefined reference sample value (REF) at least by a predefined magnitude value (MDIFF),
- the current sample value (AW) of the sequence (FA) of sample values (AW), which deviates from the predefined reference sample value (REF) at least by the predefined magnitude value (MDIFF), is predefined as the predefined reference sample value (REF) for subsequent current sample values (AW),
- a sliding average value (M) is determined as a function of the sequence (FT) of transformation values (TW), and
- pulses (IMP) in the input signal are recognized as a function of the sliding average value (M).

2. Method according to Claim 1, in which the current sample value (AW) of the sequence (FA) of sample values (AW), which deviates from the predefined reference sample value (REF) at least by the predefined magnitude value (MDIFF), is added as the transformation value (TW) to the sequence (FT) of transformation values (TW).

3. Method according to either of the preceding claims, in which
- an amplitude (AMP) of at least one pulse (IMP) is determined, and
- the predefined magnitude value (MDIFF) is predefined as a function of the determined amplitude (AMP) of the at least one pulse (IMP) and a predefined number of amplitude sections into which the determined amplitude (AMP) of the at least one pulse (IMP) is to be divided.

4. Method according to one of the preceding claims, in which the input signal or a signal which is derived from this input signal is supplied to a threshold value switching unit (SS), and the sliding average value (M) is predefined to the threshold value switching unit (SS) as a threshold value or a threshold value which is determined as a function of the sliding average value (M).

5. Device for recognizing pulses (IMP) in an input signal, which device is designed
- to transform a sequence (FA) of sample values (AW), which is formed as a function of the input signal or which is formed by the input signal, into a sequence (FT) of transformation values (TW) by in each case adding a transformation value (TW), which represents a current sample value (AW) of the sequence (FA) of sample values (AW), to the sequence (FT) of transformation values (TW) when this current sample value (AW) of the sequence (FA) of sample values (AW) deviates from a predefined reference sample value (REF) at least by a predefined magnitude value (MDIFF),
- to predefine the current sample value (AW) of the sequence (FA) of sample values (AW), which deviates from the predefined reference sample value (REF) at least by the predefined magnitude value (MDIFF), as the predefined reference sample value (REF) for subsequent current sample values (AW),
- to determine a sliding average value (M) as a function of the sequence (FT) of transformation values (TW), and
- to recognize pulses (IMP) in the input signal as a function of the sliding average value (M).

## Revendications

1. Procédé permettant d'identifier des impulsions (IMP) dans un signal d'entrée, procédé au cours duquel
- une suite (FA) de valeurs explorées (AW), laquelle suite est formée en fonction du signal d'entrée ou est formée par le signal d'entrée, est transformée en une suite (FT) de valeurs transformées (TW) en ajoutant à chacune d'elles une valeur de transformation (TW) représentant une valeur (AW) explorée en temps réel et faisant partie de la suite (FA) de valeurs explorées (AW) pour donner la suite (FT) de valeurs transformées (TW), lorsque cette valeur (AW) explorée en temps réel et faisant partie de la suite (FA) de valeurs explorées (AW) diffère au moins d'une valeur donnée (MDIFF) par rapport à une valeur d'exploration de référence donnée (REF),
- la valeur (AW) explorée en temps réel et faisant partie de la suite (FA) de valeurs explorées (AW), qui diffère au moins de la valeur donnée (MDIFF) par rapport à la valeur d'exploration de référence donnée (REF), est définie en tant que valeur d'exploration de référence donnée (REF) pour les valeurs explorées en temps réel (AW) ultérieures,
- en fonction de la suite (FT) de valeurs transformées (TW), une valeur moyenne à échelle mobile (M) est déterminée et
- des impulsions (IMP) sont identifiées dans le signal d'entrée en fonction de la valeur moyenne à échelle mobile (M).

2. Procédé selon la revendication 1, au cours duquel la valeur (AW) explorée en temps réel et faisant partie de la suite (FA) de valeurs explorées (AW), qui diffère au moins de la valeur donnée (MDIFF) par rapport à la valeur d'exploration de référence donnée (REF), est définie en tant que valeur transformée (TW) et faisant partie de la suite (FT) de valeurs transformées (TW).

3. Procédé selon l'une des revendications précédentes, au cours duquel
- on détermine l'amplitude (AMP) de au moins une impulsion (IMP) et
- on donne la valeur donnée (MDIFF) en fonction de l'amplitude (AMP) déterminée pour la au moins une impulsion (IMP) et d'un nombre donné de fractions d'amplitude en lesquelles l'amplitude (AMP) déterminée pour la au moins une impulsion (IMP) doit être divisée.

4. Procédé selon l'une des revendications précédentes, au cours duquel le signal d'entrée ou un signal qui est déduit de ce signal d'entrée est appliqué à une unité de commutation à seuil (SS) et au cours duquel la valeur moyenne à échelle mobile (M) en tant que valeur seuil ou une valeur de seuil déterminée en fonction de la valeur moyenne à échelle mobile (M) est donnée à l'unité de commutation à seuil (SS) en tant que seuil.

5. Dispositif permettant d'identifier des impulsions (IMP) dans un signal d'entrée, ledit dispositif étant conçu
- pour transformer une suite (FA) de valeurs explorées (AW), laquelle suite est formée en fonction du signal d'entrée ou est formée par le signal d'entrée, en une suite (FT) de valeurs transformées (TW) en ajoutant à chacune d'elles une valeur de transformation (TW) représentant une valeur (AW) explorée en temps réel et faisant partie de la suite (FA) de valeurs explorées (AW) pour donner la suite (FT) de valeurs transformées (TW), lorsque cette valeur (AW) explorée en temps réel et faisant partie de la suite (FA) de valeurs explorées (AW) diffère au moins d'une valeur donnée (MDIFF) par rapport à une valeur explorée de référence donnée (REF),
- pour définir la valeur (AW) explorée en temps réel et faisant partie de la suite (FA) de valeurs explorées (AW), qui diffère au moins de la valeur donnée (MDIFF) par rapport à la valeur explorée de référence donnée (REF), en tant que valeur explorée de référence donnée (REF) pour les valeurs explorées en temps réel (AW) ultérieures,
- pour déterminer, en fonction de la suite (FT) de valeurs transformées (TW), une valeur moyenne à échelle mobile (M) et
- pour identifier des impulsions (IMP) dans le signal d'entrée en fonction de la valeur moyenne à échelle mobile (M).
